# EUROPEAN PATENT SPECIFICATION

(11) **EP 0 524 862 B1**
(45) Date of publication and mention of the grant of the patent: **18.12.1996**
(21) Application number: 92402057.1
(22) Date of filing: 16.07.1992
(51) Int. Cl.: H01L 39/22, H01L 39/24

(54) **Josephson junction device of oxide superconductor and process for preparing the same**
Vorrichtung mit Josephson-Übergang aus supraleitendem Oxyd und Verfahren zu seiner Herstellung
Dispositif à jonction Josephson en oxyde supraconducteur et procédé pour sa fabrication

(30) Priority: 16.07.1991 JP 201220/91; 16.07.1991 JP 201221/91
(43) Date of publication of application: 27.01.1993
(73) Proprietor: Sumitomo Electric Industries, Ltd., Osaka 541 (JP)
(72) Inventor: Tanaka, Saburo, c/o Itami Works of Sumitomo, Itami-shi, Hyogo (JP); Matsuura, Takashi, c/o Itami Works of Sumitomo, Itami-shi, Hyogo (JP); Itozaki, Hideo, c/o Itami Works of Sumitomo, Itami-shi, Hyogo (JP)
(74) Representative: Polus, Camille

(56) References cited:
- EP-A- 0 327 493
- WO-A-92/16974
- GB-A- 2 140 998
- APPLIED PHYSICS LETTERS. vol. 59, no. 6, 5 August 1991, NEW YORK US pages 733 - 735; K. CHAR ET AL: 'Bi-epitaxial grain boundary junctions in YBa2Cu3O7'
- APPLIED PHYSICS LETTERS. vol. 57, no. 7, 13 August 1990, NEW YORK US pages 727 - 729; R. GROSS ET AL: 'Low noise YBa2Cu3O7-d grain boundary junction dc SQUIDs'
- APPLIED PHYSICS LETTERS. vol. 58, no. 19, 13 May 1991, NEW YORK US pages 2168 - 2170; S. M. GARRISON ET AL: 'Observation of two in-plane epitaxial states in YBa2Cu3O7-d films on yttria-stabilized ZrO2'
- APPLIED PHYSICS LETTERS. vol. 56, no. 22, 28 May 1990, NEW YORK US pages 2243 - 2245; R. RAMESH ET AL: 'Epitaxy of Y-Ba-Cu-O thin films grown on single-crystal MgO'
- MICROELECTRONIC ENGINEERING. vol. 9, no. 1-4, May 1989, AMSTERDAM NL pages 349 - 351; D. MAILLY ET AL: 'Experimental setup for the measurement of persistent current in a GaAs/GaAlAs single loop'

## Description

### Background of the Invention

### Field of the invention

The present invention relates to a Josephson junction device of an oxide superconductor having at least one Josephson junction and a process for preparing the Josephson junction device, and more specifically to a Josephson junction device of an oxide superconductor, of which the tunnel barrier is constituted of a grain boundary of two single crystal oxide superconductor regions and a process for preparing the Josephson junction and the superconducting device.

### Description of related art

A Josephson junction which is one of superconducting junctions can be realized in various structures. Among the various structures, the most preferable structure in practice is a stacked junction realized by a thin non-superconductor layer sandwiched between a pair of superconductors. However, a point contact type junction, a Dayem bridge type junction and a variable thickness bridge type junction which are composed of a pair of superconductor regions which are weakly linked to each other also exhibit Josephson effect. In general, these Josephson junctions have fine structures in which the superconductor and non-superconductor are composed of thin films.

In order to realize a stacked type junction by using an oxide superconductor, a first oxide superconductor thin film, a non-superconductor thin film and a second oxide superconductor thin film are stacked on a substrate in the named order.

In the above mentioned stacked type junction, an insulator MgO etc., a semiconductor Si etc., and a metal Au etc. are used for the non-superconductor layers of different applications so that each superconducting junction has different properties.

The thickness of the non-superconductor layer of the stacked type junction is determined by the coherence length of the superconductor. In general, the thickness of the non-superconductor layer of the stacked type junction must be within a few times of the coherence length of the superconductor. On the other hand, since oxide superconductor materials have a very short coherence length, therefore, a thickness of a non-superconductor layer must be about a few nanometers.

However, the superconductor layers and the non-superconductor layer of the stacked type junction must be of high crystallinity for favorable junction properties, which are composed of single crystals or composed of polycrystals which are oriented in almost same direction. It is difficult to stack an extremely thin and high crystalline non-superconductor layer on an oxide superconductor layer. Additionally, it is very difficult to stack a high crystalline oxide superconductor layer on the non-superconductor layer stacked on an oxide superconductor layer. Though the stacked structure including a first oxide superconductor layer, a non-superconductor layer and a second oxide superconductor layer is realized, the interfaces between the oxide superconductor layers and the non-superconductor layer are not in good condition so that the stacked type junction does not function in good order.

In order to manufacture a point type junction, a Dayem bridge type junction and a variable thickness bridge type junction by using oxide superconductor, very fine processings which realize a weak link of a pair of superconductor are necessary. It is very difficult to conduct a fine processing with good repeatability.

The point contact type junction has been formed of two oxide superconductor thin films which are in contact with each other in a extremely small area which constitutes the weak link of the Josephson junction.

The Dayem bridge type junction has been formed of a constant thickness oxide superconductor thin film which is formed on a substrate and which is patterned in a plan view, so that a superconductor thin film region having a greatly narrow width is formed between a pair of superconductor thin film regions having a sufficient width. In other words, the pair of superconductor thin film regions having a sufficient width are coupled to each other by the superconductor thin film region having the greatly narrow width. Namely, a weak link of the Josephson junction in the superconductor thin film is formed at the greatly narrow width region.

On the other hand, the variable thickness bridge type junction has been formed of an oxide superconductor thin film of a sufficient thickness which is formed on a substrate and which is partially etched or thinned in a thickness direction, so that a thinned oxide superconductor thin film portion is formed between a pair of superconductor thin film portions having the sufficient thickness. In other words, the pair of superconductor thin film portions having the sufficient thickness are coupled to each other by the thinned oxide superconductor thin film portion. Accordingly, a weak link of the Josephson junction is formed at the reduced thickness portion of the oxide superconductor thin film.

As would be understood from the above, a characteristics of the Josephson device has a close relation to the contact area of the superconductor thin film in the point contact type Josephson device, the width of the superconductor thin film region having the greatly narrow width in the Dayem bridge type Josephson device, and to the thickness of the thinned oxide superconductor thin film portion in the variable thickness bridge type Josephson device, both of which form the weak link of the Josephson junction. Therefore, in order to obtain a desired characteristics with a good repeatability, a high precision on a sub-micron level of the processing such as the etching is required.

The Dayem bridge type Josephson device can be said to be more preferable than the variable thickness bridge type Josephson device, since the Dayem bridge type Josephson device has a relatively planer surface, which is preferred in a integrated circuit. However, in order to form the weak link in the Dayem bridge type Josephson device, it is required to pattern an oxide superconductor thin film having the thickness on the order of 0.5µm to 1.0µm into a width of not greater than 0.2µm. However, it is very difficult to conduct this fine patterning with good repeatability.

On the other hand, in the variable thickness bridge type Josephson device, the very fine pattering is not required in order to form the weak link. However, it is very difficult to uniformly control the remaining thickness of the thinned portion forming the weak link. In addition, the variable thickness bridge type Josephson device cannot have a satisfactorily planer surface. This is not preferable to be integrated circuit application.

Other various structures are known.

It is known from "Applied Physics Letters, Vol. 56, N°. 22, 28 May 1990, p. 2243-2245" to grow a YBCO oxide superconductor thin film on a Mgo substrate as a mosaic structure to form a grain boudary.

"Applied Physics Letters, Vol. 57, N° 7, 13 August 1990, P. 727-729 discloses grain boundary junctions used as weak links in a SQUID loop structure, in which the junctions are step edge type junctions.

It is also known from WO-A-92/16974, which is relevant with regard to novelty only, a crystalline structure comprising a superconducting film overlying first and second regions of a substrate, the first region being covered by a seed layer.

Nevertheless, in the prior art, it is almost impossible to manufacture a superconducting device for example a dc SQUID (superconducting quantum interference device) which has multiple homogeneous Josephson junction by using an oxide superconductor.

### Summary of the invention

Accordingly, it is an object of the present invention to provide a Josephson junction device including a weak link of the Josephson junction composed of an oxide superconductor material and planar surface, which overcomes the above mentioned defects of the conventional ones.

Another object of the present invention is to provide a method for manufacturing a Josephson junction device with good repeatability by using existing established processing techniques.

The above and other objects of the present invention are achieved in accordance with the present invention by a Josephson junction device according to Claim 1.

The oxide superconductor thin film can include two apart portions between the two portions, which cross the step portion formed of the oxide thin film so that each of the two apart portions includes the grain boundary which constitutes the weak link of the Josephson junction.

The oxide superconductor thin film can be formed in an annular shape which includes two apart portions crossing the step portion each of which includes the grain boundary which constitutes the weak link of Josephson junction just on the step portion formed by the oxide thin film. In this case, the Josephson junction device constitutes a dc SQUID.

In order to stabilize the Josephson junction properties of the Josephson junction device in accordance with the present invention, it is effective to narrow the portion of the oxide superconductor thin film, which crosses the step portion formed of the oxide thin film so as to have a narrower width than other portions. Preferably, the narrow portion of the oxide superconductor thin film has a width of 1.5 to 15 µm and a length of 5 to 50 µm. The width of the narrow portion of the oxide superconductor thin film of the Josephson junction device in accordance with the present invention is far larger than that of the greatly narrow bridge of a conventional Dayem bridge type Josephson junction device. Therefore, it is possible to relax the limitation in the fine processing techniques such as a fine-etching or a fine-patterning which has been required in the case that conventional Dayem bridge type Josephson junction device.

The oxide thin film which is constituted of a single crystal of which lattices shift at angle of 45° to that of the principal surface of the substrate is formed of Eu₁Ba₂Cu₃O_{7-y,} Gd₁Ba₂Cu₃O_{7-z}, or Sm₁Ba₂Cu₃O₇₋ᵥ. When these oxide thin films are deposited on a single crystal oxide substrate such as a MgO (100) substrate, a SrTiO₃ (110) substrate, an yttrium stabilized zirconia (YSZ) substrate, etc., the oxide thin films grow epitaxially so as to shift their lattices at angle of 45° to lattices of the principal surface of the substrates.

On the other hand, the oxide superconductor thin film deposited on the oxide thin film grows eptaxially so as to conform their lattices to lattices of the oxide thin film.

For this effect, the oxide thin film needs high crystallinity and preferably has a thickness of 1 to 10 nanometers. If the thickness of the oxide thin film is less than 1 nanometer, the oxide grows in the form of islands or in the form of a film of poor crystallinity. If the thickness of the oxide thin film exceeds 10 nanometer, a step is generated clearly on the upper surface of the oxide superconductor thin film, which prevent from composing a planar type device.

The compound oxide superconductor thin film is formed of a high-T_{c} (high critical temperature) oxide superconductor, preferably, formed of a high-T_{c} copper-oxide type compound oxide superconductor for example a Y-Ba-Cu-O type compound oxide superconductor material, and Bi-Sr-Ca-Cu-O type compound oxide superconductor material, and Tl-Ba-Ca-Cu-O type compound oxide superconductor material.

In addition, the substrate can be formed of a single crystal oxide substrate such as a MgO (100) substrate, a SrTiO₃ (110) substrate, an yttrium stabilized zirconia (YSZ) substrate, etc.

According to another aspect of the present invention, there is provided a process of manufacturing a Josephson junction device according to Claim 9.

The process can include a step of narrowing a portion of the oxide superconductor thin film, which crosses the step portion formed of the oxide thin film by a reactive ion etching process.

In a preferred embodiment, the oxide superconductor thin film is formed by using a silicone plate mask so that the oxide superconductor thin film is shaped so as to include two apart potions crossing the step portion formed of the oxide thin film, each of which includes the grain boundary which constitutes the weak link of the Josephson junction. In this case, the oxide superconductor thin film can be shaped so as to include two apart potions crossing the step portion formed of the oxide thin film, each of which includes the grain boundary which constitutes the weak link of the Josephson junction.

The above and other objects, features and advantages of the present invention will be apparent from the following description of preferred embodiments of the invention with reference to the accompanying drawings.

### Brief Description of the Drawings

Figures 1A to 1C are diagrammatic views for illustrating one embodiment of the process for manufacturing the Josephson device in accordance with the present invention, in that Figures 1A and 1B show diagrammatic sectional views, Figure 1BB shows a plane view of Figure 1B and Figure 1C shows a diagrammatic plane view;
Figures 2 is a diagrammatic plane view of a preferred embodiment of the dc SQUID in accordance with the present invention; and
Figures 3 is a graph of the output voltage against the magnetic field for the dc SQUID shown in Figure 2.

### Description of the Preferred embodiments

### Embodiment 1

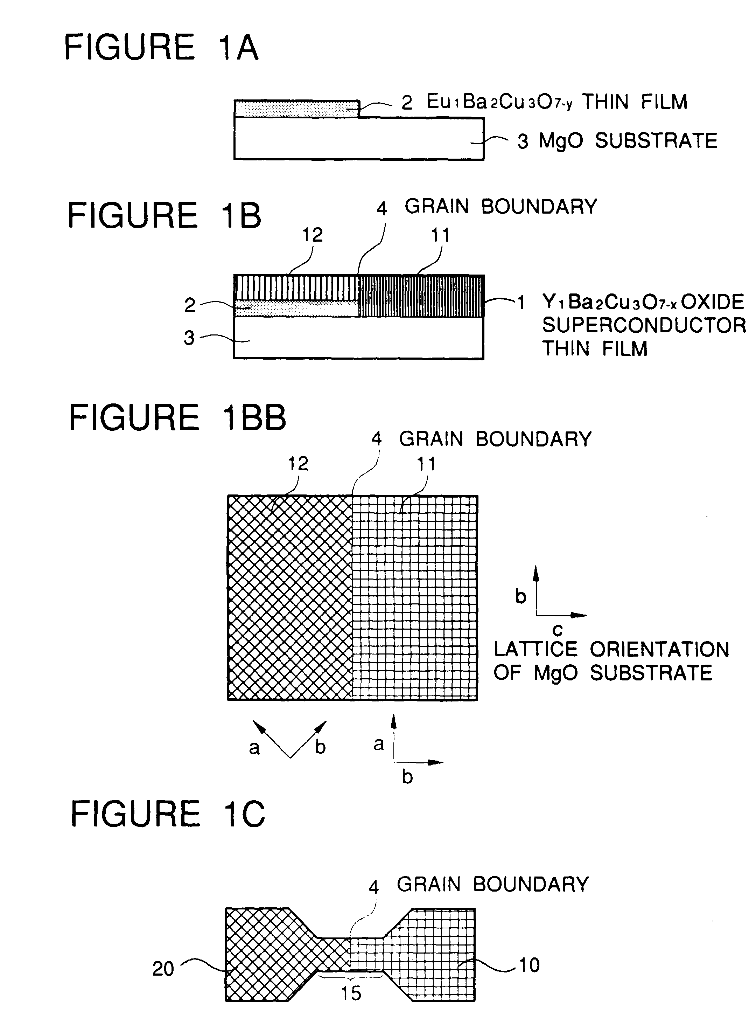

Referring to Figures 1A to 1C, the process in accordance with the present invention for manufacturing the Josephson device will be described.

As shown in Figure 1A, an Eu₁Ba₂Cu₃O_{7-y} thin film 2 having a thickness of 5 nanometers was deposited on the left half of the surface of a MgO (100) single crystal substrate 3 by a sputtering process. The conditions of the sputtering process were as follows:

| | | |
|---|---|---|
| Temperature of substrate | | 630°C |
| Sputtering gases | Ar | 8 sccm |
| | O₂ | 4 sccm |
| Pressure | 6,665 Pa | (5 x 10⁻² Torr) |

The Eu₁Ba₂Cu₃O_{7-y} thin film 2 was composed of a single crystal of which *a*-axes and *b*-axes shifted at angle of 45° to *b*-axes and *c*-axes of the lattices of the surface of the MgO substrate 3.

Then, as shown in Figure 1B, a *c*-axis oriented Y₁Ba₂Cu₃ O₇₋ₓ oxide superconductor thin film 1 having a thickness of 300 nanometers were deposited on the Eu₁Ba₂Cu₃O_{7-y} thin film 2 and the exposing right half of the surface of the MgO (100) single crystal substrate 3 by a sputtering process. The conditions of the sputtering process were as follows:

| | | |
|---|---|---|
| Temperature of substrate | | 630°C |
| Sputtering gases | Ar | 8 sccm |
| | O₂ | 4 sccm |
| Pressure | 6,665 Pa | (5 x 10⁻² Torr) |

The *c*-axis oriented Y₁Ba₂Cu₃O₇₋ₓ oxide superconductor thin film 1 grew epitaxially so as to conform its lattices to those of the Eu₁Ba₂Cu₃O_{7-y} thin film 2 and MgO substrate 3. Therefore, as shown in Figure 1BB, the *a*-axes and *b*-axes of lattices of a portion 12 of the *c*-axis oriented Y₁Ba₂Cu₃O₇₋ₓ oxide superconductor thin film 1, which grew on the Eu₁Ba₂Cu₃O_{7-y} thin film 2 sifted at angle of 45° to those of a portion 11 of the Y₁Ba₂Cu₃O₇₋ₓ oxide superconductor thin film 1, which grew directly on the MgO substrate 3. A grain boundary 4 was created on the interface between the portions 11 and 12, which was just on the step formed by the Eu₁Ba₂Cu₃O_{7-y} thin film 2. The portions 11 and 12 of the Y₁Ba₂Cu₃O₇₋ₓ oxide superconductor thin film 1 were linked weakly by the grain boundary 4 so that the Josephson junction of which the weak link was constituted of the grain boundary 4 was formed.

Finally, as shown in Figure 1C, the Y₁Ba₂Cu₃O₇₋ₓ oxide superconductor thin film 1 was etched by a reactive ion etching process so that the narrow portion 15 having a length of 10 µm and a width of 5 µm, on the center portion of which the grain boundary 4 was positioned, was created between portions 10 and 20 having a sufficient width. The width of the narrow portion 15 was not so narrow as that of a conventional Dayem bridge type Josephson device.

Thus, the Josephson device as shown in Figure 1C was completed. The Josephson device manufactured by the method in accordance with the present invention was constituted of an oxide superconductor thin film which had a planar surface and a portion 15 having a narrow width between two portions 11 and 12 having a sufficient width. The lattice orientations of two portions 11 and 12 were different from each other so that the two portions 11 and 12 were weakly linked by the grain boundary 4 in the narrow portion 15, which constituted the superconducting barrier of the Josephson device.

A current-voltage characteristics of the above mentioned Josephson device was measured at a temperature of 85K. When a microwave of 15 GHz and of 0.2 mW was irradiated, clear Shapiro steps of was observed at multiple voltages of 31 µV, and therefore, it could be ascertained that the Josephson junction was realized in the device.

As explained above, if the above mentioned Josephson device is manufactured in accordance with the above mentioned process, the limitation in the fine processing technique required for manufacturing the Josephson device is relaxed. In addition, since the superconducting barrier is constituted of the grain boundary, it become easy to form the superconducting barrier sharply. Accordingly, it is easy to manufacture the Josephson device with good repeatability, and the manufactured Josephson device has a stable performance.

### Embodiment 2

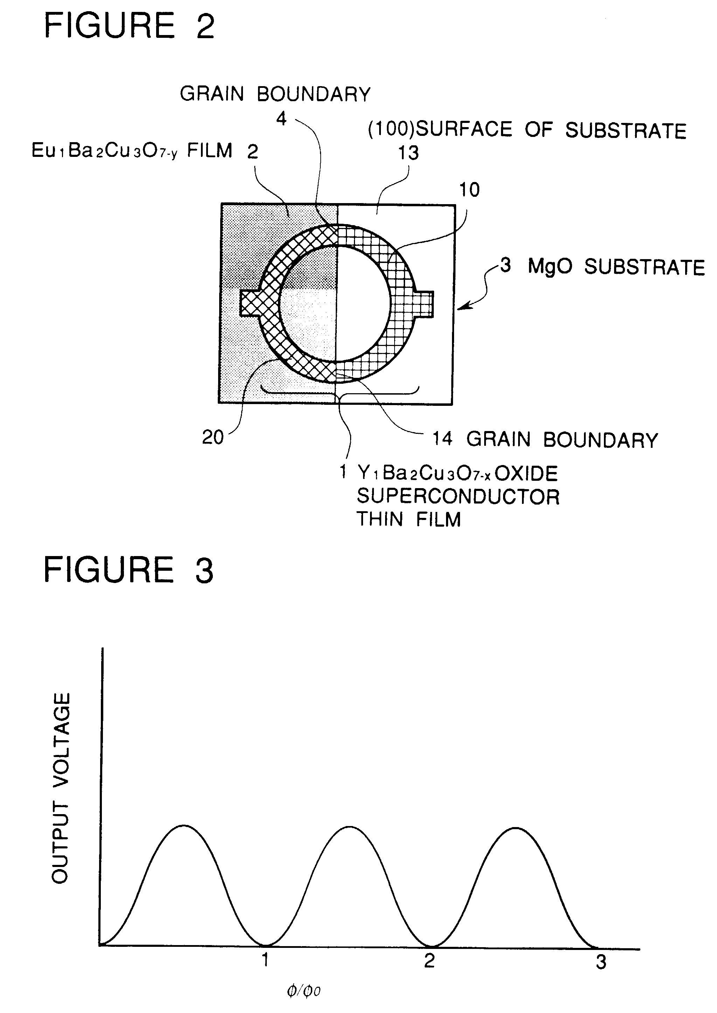

Referring to Figure 2, there is shown a diagrammatic plane view of one embodiment of the superconducting device in accordance with the present invention. The Josephson junction device shown in this embodiment is a dc SQUID.

The dc SQUID includes a MgO (100) substrate 3, a Eu₁Ba₂Cu₃O_{7-y} thin film 2 deposited on the left half of the surface of the MgO substrate 3 and an annular shaped *c*-axis oriented Y₁Ba₂Cu₃O₇₋ₓ oxide superconductor thin film 1 formed on the MgO substrate 3 and the Eu₁Ba₂Cu₃O_{7-y} thin film 2. The Y₁Ba₂Cu₃O₇₋ₓ oxide superconductor thin film 1 is formed an annular ring shape of which two portions cross the step portion formed of the a Eu₁Ba₂Cu₃O_{7-y} thin film 2. The Eu₁Ba₂Cu₃O_{7-y} thin film 2 is composed of a single crystal of which *a*-axes and *b*-axes shifted at angle of 45° to *b*-axes and *c*-axes of the lattices of the surface of the MgO substrate 3.

The Y₁Ba₂Cu₃O₇₋ₓ oxide superconductor thin film 1 grows epitaxially so as to conform its lattices to those of the Eu₁Ba₂Cu₃O_{7-y} thin film 2 and MgO substrate 3. Therefore, the *a*-axes and *b*-axes of lattices of a portion 20 of the Y₁Ba₂Cu₃O₇₋ₓ oxide superconductor thin film 1, which is deposited on the Eu₁Ba₂Cu₃O_{7-y} thin film 2 sift at angle 45° to those of a portion 10 of the Y₁Ba₂Cu₃O₇₋ₓ oxide superconductor thin film 1, which is deposited on the surface 13 of the MgO substrate 3.

Grain boundaries 4 and 14 are formed on the interfaces between the portions 10 and 20 of the Y₁Ba₂Cu₃O₇₋ₓ oxide superconductor thin film 1 just on the step portion formed by the Eu₁Ba₂Cu₃O_{7-y} thin film 2. The portions 10 and 20 of the Y₁Ba₂Cu₃O₇₋ₓ oxide superconductor thin film 1 are linked weakly by the grain boundaries 4 and 14 which constituted the superconducting barriers of the Josephson junctions.

The above mentioned dc SQUID was manufactured by the following method in accordance with the present invention. At first, an Eu₁Ba₂Cu₃O_{7-y} thin film 2 was deposited on the left half of the MgO (100) substrate 3 by a sputtering process. The sputtering was performed under the same condition as that of the Embodiment 1.

Then, an annular shaped Y₁Ba₂Cu₃O₇₋ₓ oxide superconductor thin film 1 was deposited on the Eu₁Ba₂Cu₃O_{7-y} thin film 2 and the exposing right half of the surface of the MgO (100) substrate 3 by a sputtering process in which patterned silicone plate was used as a mask. As mentioned above, *a*-axes and *b*-axes of the lattices of the portion 20 of the Y₁Ba₂Cu₃O₇₋ₓ oxide superconductor thin film 1, which was deposited on the Eu₁Ba₂Cu₃O_{7-y} thin film 2 sift at angle of 45° to those of a portion 10 of the Y₁Ba₂Cu₃O₇₋ₓ oxide superconductor thin film 1, which was deposited on the surface 13 of the MgO substrate 3.

A characteristics of the above mentioned dc SQUID was measured while changing temperature. When a faint magnetic field was irradiated, the output voltage of the dc SQUID varied as the graph shown in Figure 3, and this variation of the output voltage was clearly observed at temperatures up to 85K. Therefore, it could be ascertained that the dc SQUID had excellent properties.

As explained above, if the above mentioned dc SQUID is manufactured in accordance with the above mentioned process, the limitation in the fine processing technique required for manufacturing the dc SQUID is relaxed. In addition, since the superconducting barriers are constituted of the grain boundaries, it become easy to form sharp superconducting barriers of which properties are linear up. Accordingly, it is easy to manufacture the dc SQUID with good repeatability, and the manufactured dc SQUID has a stable performance.

The invention has thus been shown and described with reference to the specific embodiments. However, it should be noted that the present invention is in no way limited to the details of the illustrated structures but converts and modifications may be made within the scope of the appended claims.

## Claims

1. A Josephson junction device comprising a substrate (3) and an oxide superconductor thin film of high-Tc copper-oxide compound superconductor, formed on a principal surface of the substrate, which includes two portions (11,12;10,20) constituted of single crystals of the oxide superconductor, the lattices of one of which shift at an angle of 45° to that of the other, and a grain boundary between (4;4,14) said portions, which constitutes a weak link of the Josephson junction, characterized in that the Josephson junction device further includes an oxide thin film (2) of Eu₁Ba₂Cu₃O_{7-y}, Gd₁Ba₂Cu₃O_{7-y} or Sm₁Ba₂Cu₃O₇₋ᵥ formed on a portion of the principal surface of the substrate, which is constituted of a single crystal of which lattices shift at an angle of 45 to that of the principal surface of the substrate on which one of said two portions (12;20) of the oxide superconductor thin film is formed and the other portion (11;10) of the superconductor thin film is formed on the principal surface of the substrate directly so that the lattices of said two portions of the oxide superconductor thin film are respectively linear up to those of the oxide thin film and the principal surface of the substrate and the grain boundary (4;4,14) which constitutes a weak link of the Josephson junction is formed just on the step portion formed of the oxide thin film.

2. A Josephson junction device as claimed in Claim 1, characterized in that the oxide thin film (2) has a thickness of 1 to 10 nanometers.

3. A Josephson junction device as claimed in Claim 1 or 2, characterized in that said oxide superconductor thin film (1) includes two apart portions between said two portion (10,20), which cross the step portion formed of the oxide thin film (2) so that each of the two apart portions includes the grain boundary (4,14) which constitutes the weak link of the Josephson junction.

4. A Josephson junction device as claimed in Claim 3, characterized in that said oxide superconductor thin film (1) is formed in an annular shape so that the Josephson junction device constitutes a dc SQUID.

5. A Josephson junction device as claimed in anyone of Claims 1 to 4, characterized in that the portion of said oxide superconductor thin film (1), which crosses the step portion formed of said oxide thin film (2) has a narrower width than other portions of said oxide superconductor thin film (1).

6. A Josephson junction device as claimed in Claim 5, characterized in that the narrow portion of the oxide superconductor thin film has a width of 1.5 to 15 µm and a length of 5 to 50 µm.

7. A Josephson junction device as claimed in anyone of Claims 1 to 6, characterized in that said oxide superconductor thin film (1) is formed of an oxide superconductor material selected from the group consisting of a Y-Ba-Cu-O type compound oxide superconducting material, a Bi-Sr-Ca-Cu-O type compound superconductor material, and a Tl-Ba-Ca-Cu-O type compound oxide superconductor material.

8. A Josephson junction device as claimed in anyone of Claims 1 to 7, characterized in that the substrate is formed of a material selected from the group consisting of a MgO(100) substrate, a SrTiO₃ (110) substrate and an yttrium stabilized zirconia (YSZ) substrate.

9. A process of manufacturing a Josephson junction device, comprising the steps of forming on a portion of a principal surface of a substrate (3) an oxide thin film (2) which is composed of a single crystal of Eu₁Ba₂Cu₃O_{7-y}, Gd₁Ba₂Cu₃O_{7-y} or Sm₁Ba₂Cu₃O₇₋ᵥ the lattices of which shift at an angle of 45° to the lattices of the surface of the substrate, and forming an oxide superconductor thin film of a high-T_{c} copper-oxide compound superconductor on the oxide thin film and the exposing principal surface of the substrate so that the oxide superconductor thin film grows epitaxially so as to conform its lattices to those of the oxide thin film and substrate and the lattices of a portion of the oxide superconductor thin film, which is deposited on the oxide thin film shift at an angle of 45° to those of a portion of the oxide superconductor thin film, which is deposited on the surface of the substrate to form a grain boundary (4;4,14) between the two portions of the oxide superconductor thin film just on a step portion formed of the oxide thin film, which constitutes the weak link of the Josephson junction.

10. A process as claimed in claim 9, characterized in that the process further includes a step of narrowing a portion (15) of the oxide superconductor thin film, which crosses the step portion formed of the oxide thin film by a reactive ion etching process.

11. A process as claimed in claim 9 or 10, characterized in that the oxide superconductor thin film is formed by using a silicone plate mask so that the oxide superconductor thin film is shaped so as to include two apart portions crossing the step portion formed of the oxide thin film, each of which includes the grain boundary which constitutes the weak link of the Josephson junction.

12. A process as claimed in claim 11, characterized in that the oxide superconductor thin film is shaped into an annnular shape which includes two potions crossing the step portion formed of the oxide thin film, each of which includes the grain boundary which constitutes the weak link of the Josephson junction.

## Patentansprüche

1. Vorrichtung mit Josephson-Übergang mit einem Substrat (3) und mit einer oxidischen supraleitenden Dünnschicht aus einem supraleitenden Kupfer-Verbundoxid mit hoher Tc, die auf einer Hauptoberfläche des Substrats ausgebildet ist und die zwei Abschnitte (11, 12; 10, 20) aufweist, die aus Einkristallen des supraleitenden Oxids bestehen, wobei ihre Gitter unter einem Winkel von 45° zueinander angeordnet sind und wobei eine Korngrenze (4; 4, 14) die Abschnitte trennt, welche die schwache Verbindung des JosephsonÜbergangs bildet, dadurch gekennzeichnet, daß die Vorrichtung mit Josephson-Übergang außerdem eine oxidische Dünnschicht (2) aus Eu₁Ba₂Cu₃O_{7-y} Gd₁Ba₂Cu₃O_{7-y} oder Sm₁Ba₂Cu₃O_{7-y} aufweist, die auf einem Abschnitt der Hauptoberfläche des Substrats ausgebildet ist und die aus einem Einkristall besteht, dessen Gitter einen Winkel mit 45° zu demjenigen der Hauptoberfläche des Substrats bildet, auf dem einer der beiden Abschnitte (12; 20) der oxidischen supraleitenden Dünnschicht ausgebildet ist, während der andere Abschnitt (11; 10) der supraleitenden Dünnschicht direkt auf der Hauptoberfläche des Substrats ausgebildet ist, so daß die Gitter dieser beiden Abschnitte der oxidischen supraleitenden Dünnschicht linear aufwärts zu denjenigen der oxidischen Dünnschicht und der Hauptoberfläche des Substrats und der Korngrenze (4; 4, 14) verlaufen, welche die schwache Verbindung des Josephson-Übergangs bildet und direkt im Stufenabschnitt der oxidischen Dünnschicht ausgebildet ist.

2. Vorrichtung mit Josephson-Übergang nach Anspruch 1, dadurch gekennzeichnet, daß die oxidische Dünnschicht (2) eine Dicke von 1 bis 10 Nanometern aufweist.

3. Vorrichtung mit Josephson-Übergang nach Anspruch 1 oder 2, dadurch gekennzeichnet, daß die oxidische supraleitende Dünnschicht (1) zwei nebeneinander liegende Abschnitte zwischen den beiden Abschnitten (10, 20) aufweist, welche den Stufenabschnitt in der oxidischen Dünnschicht (2) kreuzt, so daß jede der beiden nebeneinander liegenden Abschnitte eine Korngrenze (4, 14) aufweist, welche die schwache Verbindung des Josephson-Übergangs darstellt.

4. Vorrichtung mit Josephson-Übergang nach Anspruch 3, dadurch gekennzeichnet, daß die oxidische supraleitende Dünnschicht (1) eine ringförmige Gestalt aufweist, so daß die Vorrichtung mit Josephson-Übergang einen Gleichstrom-SQUID (Quanteninterferometer) bildet.

5. Vorrichtung mit Josephson-Übergang nach einem der Ansprüche 1 bis 4, dadurch gekennzeichnet, daß der Abschnitt der oxidischen supraleitenden Dünnschicht (1), welcher den Stufenabschnitt in der oxidischen Dünnschicht (2) kreuzt, eine geringere Breite als die anderen Abschnitte der oxidischen supraleitenden Dünnschicht (1) aufweist.

6. Vorrichtung mit Josephson-Übergang nach Anspruch 5, dadurch gekennzeichnet, daß dieser Abschnitt geringerer Breite der oxidischen supraleitenden Dünnschicht eine Breite von 1,5 bis 15 µm und eine Länge von 5 bis 50 µm aufweist.

7. Vorrichtung mit Josephson-Übergang nach einem der Ansprüche 1 bis 6, dadurch gekennzeichnet, daß die oxidische supraleitende Dünnschicht (1) aus einem oxidischen supraleitenden Material besteht, das ausgewählt ist aus der Gruppe bestehend aus einem supraleitenden Y-Ba-Cu-O-Verbundoxid, einem supraleitenden Bi-Sr-Ca-Cu-O-Verbundoxid und einem supraleitenden Tl-Ba-Ca-Cu-O-Verbundoxid.

8. Vorrichtung mit Josephson-Übergang nach einem der Ansprüche 1 bis 7, dadurch gekennzeichnet, daß das Substrat aus einem Material besteht, das ausgewählt ist aus der Gruppe bestehend aus einem MgO (100) Substrat, einem SrTiO₃ (110) Substrat und einem Yttrium-stabilisierten ZirkoniumdioxidSubstrat (YSZ).

9. Verfahren zur Herstellung einer Vorrichtung mit Josephson-Übergang, umfassend die Schritte des Ausbildens auf einem Abschnitt einer Hauptoberfläche eines Substrats (3), einer oxidischen Dünnschicht (2), die aus einem Einkristall aus Eu₁Ba₂Cu₃O_{7-y}, Gd₁Ba₂Cu₃O_{7-y} oder Sm₁Ba₂Cu₃O_{7-y} besteht, deren Gitter einen Winkel von 45° zum Gitter der Oberfläche des Substrats einnehmen, und des Ausbildens einer oxidischen supraleitenden Dünnschicht mit hoher Tc aus supraleitendem Kupferverbundoxid auf der oxidischen Dünnschicht und der freiliegenden Hauptoberfläche des Substrats, so daß die oxidische supraleitende Dünnschicht epitaktisch aufwächst und ihre Gitter entsprechend denjenigen der oxidischen Dünnschicht und des Substrats ausbildet, so daß das Gitter eines Abschnitts der oxidischen supraleitenden Dünnschicht, welcher auf der oxidischen Dünnschicht abgeschieden ist, einen Winkel von 45° mit demjenigen eines Abschnitts der oxidischen supraleitenden Dünnschicht einnimmt, welcher auf der Oberfläche des Substrats abgeschieden ist, um so eine Korngrenze (4; 4, 14) zwischen den beiden Abschnitten der oxidischen supraleitenden Dünnschicht direkt am Stufenabschnitt zu bilden, welcher in der oxidischen Dünnschicht ausgebildet ist und die schwache Verbindung des Josephson-Übergangs darstellt.

10. Verfahren nach Anspruch 9, dadurch gekennzeichnet, daß das Verfahren außerdem den Schritt des Einengens eines Abschnitts (15) der oxidischen supraleitenden Dünnschicht aufweist, welcher den Stufenabschnitt in der oxidischen Dünnschicht kreuzt durch ein reaktives Ionenätzverfahren.

11. Verfahren nach Anspruch 9 oder 10, dadurch gekennzeichnet, daß die oxidische supraleitende Dünnschicht gebildet wird durch Verwendung einer Silikon-Plattenmaske, so daß die oxidische supraleitende Dünnschicht so ausgeformt wird, daß sie zwei nebeneinander liegende Abschnitte aufweist, welche den Stufenabschnitt in der oxidischen Dünnschicht kreuzen, wobei jeder von ihnen eine Korngrenze aufweist, welche die schwache Verbindung des Josephson-Übergangs bildet.

12. Verfahren nach Anspruch 11, dadurch gekennzeichnet, daß die oxidische supraleitende Dünnschicht in Form eines Ringes ausgebildet wird, welcher zwei Abschnitte aufweist, die den Stufenabschnitt in der oxidischen Dünnschicht kreuzen, wobei jeder eine Korngrenze aufweist, welche die schwache Verbindung des Josephson-Übergangs bildet.

## Revendications

1. Dispositif à jonction de Josephson comprenant un substrat (3) et un film mince d'oxyde supraconducteur formé par un oxyde de cuivre supraconducteur composite à température Tc élevée, formé sur une surface principale du substrat, qui comprend deux parties (11,12;10,20) constituées de monocristaux de l'oxyde supraconducteur, les réseaux de l'un de ces cristaux étant décalé d'un angle de 45° par rapport à ceux de l'autre cristal, et une limite de grain (4;4,14) entre lesdites parties, qui constitue une liaison faible de la jonction de Josephson, caractérisé en ce que le dispositif à jonction de Josephson comprend en outre un film mince d'oxyde (2) formé de Eu₁Ba₂Cu₃O_{7-y}, Gd₁Ba₂Cu₃O_{7-y} ou Sm₁Ba₂Cu₃O₇₋ᵥ formé sur une partie de la surface principale du substrat, qui est constituée par un monocristal dont les réseaux sont décalés d'un angle de 45° par rapport à ceux de la surface principale du substrat, sur laquelle l'une desdites deux parties (12;20) du film mince d'oxyde supraconducteur est formée, tandis que l'autre partie (11;10) du film mince supraconducteur est formée directement sur la surface principale du substrat de telle sorte que les réseaux desdites deux parties du film mince d'oxyde supraconducteur sont respectivement alignés avec ceux du film mince d'oxyde, et la surface principale du substrat et la limite de grain (4;14), qui constitue une liaison faible de la jonction de Josephson, est formée précisément sur la partie étagée formée de film mince d'oxyde.

2. Dispositif à jonction de Josephson selon la revendication 1, caractérisé en ce que le film mince d'oxyde (2) possède une épaisseur de 1 à 10 manomètres.

3. Dispositif à jonction de Josephson selon la revendication 1 ou 2, caractérisé en ce que ledit film mince d'oxyde supraconducteur (1) comprend deux parties espacées entre lesdites deux parties (10,20), qui recoupent la partie étagée formée du film mince d'oxyde (2) de sorte que chacune des deux parties espacées incluent la limite de grain (4,14) qui constitue la liaison faible de la jonction de Josephson.

4. Dispositif à jonction de Josephson selon la revendication 3, caractérisé en ce que ledit film mince d'oxyde supraconducteur (1) est agencé avec une forme annulaire de sorte que le dispositif à jonction de Josephson constitue un dispositif SQUID à courant continu.

5. Dispositif à jonction de Josephson selon l'une quelconque des revendications 1 à 4, caractérisé en ce que la partie dudit film mince d'oxyde supraconducteur (1), qui recoupe la partie étagée formée dudit film mince d'oxyde (2) possède une largeur inférieure à celle d'autres parties dudit film mince d'oxyde supraconducteur (1).

6. Dispositif à jonction de Josephson selon la revendication 5, caractérisé en ce que la partie étroite du film mince d'oxyde supraconducteur possède une largeur de 1,5 à 15 µm et une longueur de 5 à 50 µm.

7. Dispositif à jonction de Josephson selon l'une quelconque des revendications 1 à 6, caractérisé en ce que ledit film mince d'oxyde supraconducteur (1) est formé d'un oxyde supraconducteur choisi dans le groupe comprenant un matériau supraconducteur constitué d'un oxyde composite du type Y-Ba-Cu-O, un matériau supraconducteur composite du tpye Bi-Sr-Ca-Cu-O, et un matériau supraconducteur formé d'un oxyde composite du type Tl-Ba-Ca-Cu-O.

8. Dispositif à jonction de Josephson selon l'une quelconque des revendications 1 à 7, caractérisé en ce que le substrat est formé d'un matériau choisi dans le groupe comprenant un substrat en MgO (100), un substrat en SrTiO₃ (110) et un substrat formé de zircone stabilisée par de l'yttrium (YSZ).

9. Procédé pour fabriquer un dispositif à jonction de Josephson, comprenant les étapes consistant à former, sur une partie d'une surface principale d'un substrat (3), un film mince d'oxyde (2), qui est formé d'un monocristal de Eu₁Ba₂Cu₃O_{6-y}, Gd₁Ba₂Cu₃O_{7-y} ou Sm₁Ba₂Cu₃O₇₋ᵥ, dont les réseaux sont décalés d'un angle de 45° par rapport aux réseaux de la surface du substrat, et former un film mince d'oxyde supraconducteur constitué d'un oxyde de cuivre supraconducteur composite à température Tc élevée sur le film d'oxyde mince et la surface principale exposée du substrat de telle sorte que le film mince d'oxyde supraconducteur croît de façon épitaxiale de manière à adapter ses réseaux à ceux du film d'oxyde mince et du substrat, et que les réseaux d'une partie du film mince d'oxyde supraconducteur, qui est déposé sur le film mince d'oxyde, sont décalés d'un angle de 45° par rapport à ceux des parties du film mince d'oxyde supraconducteur, qui est déposé sur la surface du substrat pour former une limite de grain (4;4,14) entre les deux parties du film mince d'oxyde supraconducteur précisément sur une partie étagée formée du film mince d'oxyde, qui constitue la liaison faible de la jonction de Josephson.

10. Procédé selon la revendication 9, caractérisé en ce que le procédé comprend en outre une étape consistant à rétrécir une partie (15) du film mince d'oxyde supraconducteur, qui croise la partie étagée formée sur le film mince d'oxyde au moyen d'un procédé de corrosion ionique réactive.

11. Procédé selon la revendication 9 ou 10, caractérisé en ce qu'on forme le film mince d'oxyde supraconducteur en utilisant un masque constitué d'une plaque de silicone de sorte que le film mince d'oxyde supraconducteur est conformé de manière à comporter deux parties espacées recoupant la partie étagée formée du film mince d'oxyde, dont chacune inclut la limite de grain qui constitue la liaison faible de la jonction de Josephson.

12. Procédé selon la revendication 11, caractérisé en ce que le film mince d'oxyde supraconducteur est agencé avec une forme annulaire qui inclut deux parties recoupant la partie étagée formée du film mince d'oxyde et dont chacune inclut la limite de grain qui constitue la liaison faible de la jonction de Josephson.
